# FASCICULE DE BREVET EUROPEEN

(11) **EP 3 227 468 B1**
(45) Date de publication et mention de la délivrance du brevet: **10.10.2018**
(21) Numéro de dépôt: 15822965.8
(22) Date de dépôt: 01.12.2015
(51) Int. Cl.: C23C 10/52, C23C 10/54, C23C 10/20, F01D 5/28

(54) **PROCÉDÉ DE FABRICATION D'UNE PIÈCE REVÊTUE D'UN REVÊTEMENT PROTECTEUR**
VERFAHREN ZUR HERSTELLUNG EINES MIT EINER SCHUTZSCHICHT BESCHICHTETEN TEILS
METHOD FOR MANUFACTURING A PART COATED WITH A PROTECTIVE COATING

(30) Priorité: 03.12.2014 FR 1461850
(43) Date de publication de la demande: 11.10.2017
(73) Titulaire: SAFRAN AIRCRAFT ENGINES, 75015 Paris (FR); Université de Lorraine, 54052 Nancy Cedex (FR)
(72) Inventeur: KNITTEL, Stéphane, 77550 Moissy-cramayel Cedex (FR); MATHIEU, Stéphane, 54500 Vandoeuvre lès Nancy (FR); VILASI, Michel, 54136 Bouxieres Aux Dames (FR)
(74) Mandataire: Laïk, Eric
(86) Numéro de dépôt international: PCT/FR2015/053276
(87) Numéro de publication internationale: WO 2016/087766

(56) Documents cités:
- EP-A1- 2 322 684
- EP-A2- 1 229 146
- US-A1- 2004 126 237
- US-A1- 2011 146 848
- CHEN ET AL: "Deposition of Cr-modified silicide coatings on Nb-Si system intermetallics", INTERMETALLICS, ELSEVIER SCIENCE PUBLISHERS B.V, GB, vol. 15, no. 5-6, 19 avril 2007 (2007-04-19), pages 805-809, XP022035047, ISSN: 0966-9795, DOI: 10.1016/J.INTERMET.2006.10.033

## Description

### Arrière-plan de l'invention

L'invention concerne des pièces revêtues d'un revêtement protecteur ainsi que des procédés de fabrication de telles pièces.

Actuellement au sein des parties les plus chaudes des turbomachines seuls les superalliages à base de nickel sont utilisés à l'échelle industrielle. Bien que ces superalliages à base de nickel soient revêtus d'un système de barrière thermique, leur température d'utilisation peut être limitée à 1150°C en raison de la proximité de leur point de fusion.

De récents travaux de recherche se sont focalisés sur la mise en oeuvre de nouveaux matériaux à base de métaux réfractaires capables d'être utilisés à des températures supérieures aux températures d'utilisation des superalliages à base de nickel. Ces familles de matériaux sont couramment appelées : matériaux composites à matrice métallique réfractaire.

Parmi les solutions mises en évidence, les alliages à base de niobium apparaissent comme particulièrement prometteurs afin de remplacer ou d'être utilisés en complément des superalliages à base nickel existants. Ces différents alliages ont l'avantage de présenter des points de fusion supérieurs aux superalliages existants. Par ailleurs, les alliages à base de niobium peuvent aussi avantageusement présenter des densités relativement faibles (6,5-7 g/cm³ à comparer à 8-9 g/cm³ pour les superalliages à base de nickel). De tels alliages peuvent donc avantageusement permettre de réduire significativement la masse des pièces de turbomachines, par exemple des aubages de turbine haute pression, en raison de leur faible densité et de leurs propriétés mécaniques proches de celles des superalliages à base de nickel à des températures voisines de 1100°C.

Les alliages à base de niobium peuvent généralement comporter de nombreux éléments d'addition tels que le silicium (Si), le titane (Ti), le chrome (Cr), l'aluminium (Al), le hafnium (Hf), le molybdène (Mo), ou l'étain (Sn), par exemple. Ces alliages présentent une microstructure constituée d'une matrice de niobium (Nbₛₛ) renforcée par des éléments d'additions dissous en solution solide. Cette phase assure une ténacité acceptable des alliages à basse température. A cette matrice réfractaire sont associés des précipités intermétalliques, souvent des siliciures de métaux réfractaires dont la composition et la structure peuvent varier selon les éléments d'additions (M₃Si, M₅Si₃).

Malgré les nombreux progrès réalisés concernant la composition des alliages visant à accroitre leur résistance à l'oxydation à haute température, celle-ci peut rester insuffisante pour envisager une application industrielle directe.

Il existe donc un besoin pour disposer de nouveaux matériaux présentant à la fois de bonnes propriétés mécaniques (ténacité à froid et fluage à haute température pour les pièces mobiles) ainsi qu'une bonne résistance à la corrosion ainsi qu'à l'oxydation à très haute température.

Il existe encore un besoin pour disposer de nouveaux procédés permettant d'obtenir de tels matériaux.

EP 2 322 684 A1 décrit par exemple un procédé de déposition d'un revêtement protecteur sur de tels alliages à base de niobium.

### Objet et résumé de l'invention

La présente invention vise, selon un premier aspect, un procédé de fabrication d'une pièce revêtue d'un revêtement protecteur comportant l'étape suivante :
- formation d'un revêtement protecteur sur tout ou partie de la surface d'une pièce, la pièce comportant un alliage réfractaire comportant une matrice de niobium dans laquelle des inclusions de siliciures métalliques sont présentes, le revêtement protecteur étant formé par un procédé de cémentation en caisse à partir d'un cément comportant :
   i. un mélange A de (NbₓTi₁₋ₓ)₃M₃CrSi₆ et de M_{0,6}Cr_{0,4}Si où M désigne Fe, Co ou Ni et x est compris entre 0 et 1, ou
   ii. un mélange B de M'Si, de NbSi₂ et de Nb₄M'₄Si₇ où M' désigne Fe, Co ou Ni.

Dans la suite, l'expression « mélange A » désigne un mélange de (NbₓTi₁₋ₓ)₃M₃CrSi₆ et de M_{0,6}Cr_{0,4}Si où M désigne Fe, Co ou Ni et x est compris entre 0 et 1.

Dans la suite, l'expression « mélange B » désigne un mélange de M'Si, de NbSi₂ et de Nb₄M'₄Si₇ où M' désigne Fe, Co ou Ni.

La présente invention permet avantageusement de former sur des pièces à base de niobium des revêtements protecteurs capables de développer des couches d'oxydes protectrices afin d'améliorer la tenue à l'oxydation de ces pièces sans pour autant affecter leurs propriétés mécaniques. Le procédé de cémentation en caisse permet avantageusement de traiter des pièces ayant des géométries complexes, de déposer sur celles-ci plusieurs éléments en une seule étape et d'obtenir un revêtement protecteur d'épaisseur homogène.

Le procédé selon l'invention repose sur le choix de mélanges particuliers d'alliages donneurs dans le cément utilisé (mélanges A et B ci-dessus mentionnés). Ces mélanges permettent avantageusement d'obtenir des revêtements protecteurs améliorant très significativement la résistance à l'oxydation des pièces traitées.

La pièce peut être constituée d'un alliage réfractaire comportant une matrice de niobium dans laquelle des précipités de siliciures métalliques sont présents.

Le revêtement protecteur formé peut comporter une pluralité de phases distinctes, ces phases peuvent se présenter sous forme de strates superposées les unes avec les autres. La formation de ces phases est gouvernée par l'interdiffusion à l'état solide des éléments déposés et des éléments constitutifs du substrat.

Lorsque le cément comporte un mélange B de FeSi, de NbSi₂ et de Nb₄Fe₄Si₇, le revêtement protecteur formé comporte du Nb, du Fe et du Si. En particulier, dans ce cas, plusieurs phases du revêtement protecteur peuvent chacune comporter du Nb, du Fe et du Si.

En variante, lorsque le cément comporte un mélange B de CoSi, de NbSi₂ et de Nb₄Co₄Si₇, le revêtement protecteur formé comporte du Nb, du Co et du Si. En particulier, dans ce cas, plusieurs phases du revêtement protecteur peuvent chacune comporter du Nb, du Co et du Si.

En variante encore, lorsque le cément comporte un mélange B de NiSi, de NbSi₂ et de Nb₄Ni₄Si₇, le revêtement protecteur formé comporte du Nb, du Ni et du Si. En particulier, dans ce cas, plusieurs phases du revêtement protecteur peuvent chacune comporter du Nb, du Ni et du Si.

Dans un exemple de réalisation, le cément peut comporter un mélange B et avant le début du procédé de cémentation en caisse :
- le rapport (masse de M'Si dans le cément)/(masse totale du mélange B dans le cément) peut, de préférence, être compris entre 5 % et 30%, et
- le rapport (masse de NbSi₂ dans le cément)/(masse totale du mélange B dans le cément) peut, de préférence, être compris entre 5 % et 30%, et
- le rapport (masse de Nb₄M'₄Si₇ dans le cément)/(masse totale du mélange B dans le cément) peut, de préférence, être compris entre 50% et 80%.

Par « masse totale du mélange B dans le cément », il faut comprendre la somme suivante : (masse de M'Si dans le cément) + (masse de NbSi₂ dans le cément) + (masse de Nb₄M'₄Si₇ dans le cément).

Dans un exemple de réalisation, lorsque le cément comporte un mélange B avec M' = Fe et avant le début du procédé de cémentation en caisse :
- le rapport (masse de M'Si dans le cément) / (masse totale du mélange B dans le cément) peut être compris entre 5% et 30%, par exemple entre 10% et 20%, et
- le rapport (masse de NbSi₂ dans le cément) / (masse totale du mélange B dans le cément) peut être compris entre 5% et 30%, par exemple entre 10% et 20%, et
- le rapport (masse de Nb₄M'₄Si₇ dans le cément) / (masse totale du mélange B dans le cément) peut être compris entre 50% et 80%.

De préférence, le cément peut comporter un mélange A.

La mise en oeuvre d'un tel mélange permet avantageusement d'obtenir un revêtement protecteur présentant une très bonne résistance contre l'oxydation et la corrosion à chaud. La mise en oeuvre d'un tel mélange permet de former un revêtement protecteur comportant du Nb, du Cr et du Si. En particulier, dans ce cas, plusieurs phases du revêtement protecteur peuvent chacune comporter du Nb, du Cr et du Si.

De préférence, le cément peut comporter un mélange A et M peut désigner Co ou Ni, de manière particulièrement préférée M désigne Ni.

En particulier, le cément peut comporter un mélange A et x peut être différent de 0, en particulier x peut être égal à 1. Dans ce dernier cas, le cément comporte un mélange A de Nb₃M₃CrSi₆ et de M_{0,6}Cr_{0,4}Si où M désigne Fe, Co ou Ni.

De préférence, le cément peut comporter un mélange A et x = 0. Autrement dit, le cément peut comporter un mélange A de Ti₃M₃CrSi₆ et de M_{0,6}Cr_{0,4}Si où M désigne Fe, Co ou Ni.

En plus des avantages mentionnés ci-dessus en termes de tenue à l'oxydation et à la corrosion à chaud, la mise en oeuvre d'un tel mélange permet avantageusement d'obtenir un revêtement protecteur présentant une très bonne compatibilité avec la pièce sous-jacente et, par conséquent, une très bonne adhérence à cette dernière.

Un tel mélange permet d'obtenir un revêtement protecteur comportant du Nb, du Ti et du Si. En particulier, dans ce cas, plusieurs phases du revêtement protecteur, voire la totalité de celles-ci, peuvent chacune comporter du Nb, du Ti et du Si.

La présence de Ti au sein du revêtement protecteur permet avantageusement d'obtenir une très bonne adaptation des coefficients de dilatation entre la pièce sous-jacente et le revêtement protecteur. Par ailleurs, la présence de Ti dans le mélange A peut modifier le sens de croissance du revêtement protecteur et permettre de limiter l'évaporation à haute température du Ti éventuellement contenu dans la pièce (cette évaporation peut se produire par formation d'halogénures de titane volatiles lors de la formation du revêtement protecteur).

Dans un exemple de réalisation, lorsque le cément comporte un mélange A de Ti₃Fe₃CrSi₆ et de Fe_{0,6}Cr_{0,4}Si, le revêtement protecteur formé comporte du Nb, du Ti, du Cr, du Si et du Fe. En particulier, dans ce cas, plusieurs phases du revêtement protecteur, voire la totalité de celles-ci, peuvent chacune comporter du Nb, du Ti, du Cr, du Si et du Fe.

En variante, lorsque le cément comporte un mélange A de Ti₃Co₃CrSi₆ et de Co_{0,6}Cr_{0,4}Si, le revêtement protecteur formé comporte du Nb, du Ti, du Cr, du Si et du Co. En particulier, dans ce cas, plusieurs phases du revêtement protecteur, voire la totalité de celles-ci, peuvent chacune comporter du Nb, du Ti, du Cr, du Si et du Co.

En variante encore, lorsque le cément comporte un mélange A de Ti₃Ni₃CrSi₆ et de Ni_{0,6}Cr_{0,4}Si, le revêtement protecteur formé comporte du Nb, du Ti, du Cr, du Si et du Ni. En particulier, dans ce cas, plusieurs phases du revêtement protecteur, voire la totalité de celles-ci, peuvent chacune comporter du Nb, du Ti, du Cr, du Si et du Ni.

De préférence, le cément peut comporter un mélange A et le rapport (masse de (NbₓTi₁₋ₓ)₃M₃CrSi₆ dans le cément avant le début du procédé de cémentation en caisse) / (masse de M_{0,6}Cr_{0,4}Si dans le cément avant le début du procédé de cémentation en caisse) peut être compris entre 0,9 et 1,1.

La matrice de niobium peut, par exemple, comporter des inclusions de Nb₅Si₃ et/ou des inclusions de Nb₃Si.

De préférence, la pièce peut être soumise à une température comprise entre 1100°C et 1300°C durant tout ou partie de l'étape de formation du revêtement protecteur.

De préférence, la durée du procédé de cémentation en caisse peut être comprise entre 1 heure et 100 heures, par exemple entre 2 heures et 96 heures.

Dans un exemple de réalisation, l'épaisseur du revêtement protecteur formé peut être supérieure ou égale à 15µm, par exemple être comprise entre 15 µm et 50 µm.

Il peut être avantageux de limiter l'épaisseur du revêtement protecteur à une valeur inférieure ou égale à 50 µm afin d'éviter l'obtention d'un revêtement fragile ainsi que les problématiques d'écaillage trop important lors des cycles thermiques. Il peut aussi être avantageux de réaliser un revêtement d'épaisseur supérieure ou égale à 15 µm afin d'obtenir une protection contre l'oxydation satisfaisante.

L'invention vise également une pièce comportant un alliage réfractaire comportant une matrice de niobium dans laquelle des inclusions de siliciures métalliques sont présentes, la surface de la pièce étant revêtue par un revêtement protecteur, le revêtement protecteur comportant une phase ayant la stoechiométrie (proportions atomiques) suivante :
- (NbₓTi₁₋ₓ)₃M_{β}Cr_{γ}Si_{δ}X_{ε} où M désigne Fe, Co ou Ni, X désigne un ou plusieurs autres éléments éventuellement présents, x est compris entre 0 et 1, δ est compris entre 5 et 8,5 et la somme β+γ est comprise entre 3 et 7, ou
- Nb₄M'_{η}Si_{θ}X'_{ε'} où M' désigne Fe, Co ou Ni, X' désigne un ou plusieurs autres éléments éventuellement présents, η est compris entre 3,2 et 4,8 et θ est compris entre 6 et 8.

Conformément à ce qui a été décrit plus haut, β est supérieur à 0.

Une telle pièce revêtue est susceptible d'être obtenue par mise en oeuvre d'un procédé tel que décrit plus haut. Lorsqu'un procédé tel que décrit plus haut est mis en oeuvre pour obtenir la pièce revêtue selon l'invention, l'utilisation d'un mélange A conduit à un revêtement protecteur comportant une phase de (NbₓTi₁₋ₓ)₃M_{β}Cr_{γ}Si_{δ}X_{ε} et l'utilisation d'un mélange B conduit à un revêtement protecteur comportant une phase de Nb₄M'_{η}Si_{θ}X'_{ε'}.

Les pièces revêtues selon l'invention présentent une très bonne résistance contre l'oxydation et la corrosion à chaud.

De préférence, le revêtement protecteur est tel que la phase ayant l'une des stoechiométries indiquées ci-dessus soit présente sur la surface externe du revêtement protecteur, ladite surface externe étant située du côté opposé à la surface de la pièce revêtue.

X et X' peuvent être l'un au moins de Al et/ou Hf. Dans un exemple de réalisation, ε et ε' peuvent être inférieurs ou égaux à 1, par exemple à 0,5, par exemple à 0,3.

Lorsque le revêtement protecteur comporte une phase de (NbₓTi₁₋ₓ)₃M_{β}Cr_{γ}Si_{δ}X_{ε}, le silicium peut être présent dans cette phase en une teneur atomique comprise entre 44% et 48%. Lorsque le revêtement protecteur comporte une phase de Nb₄M'_{η}Si_{θ}X'_{ε'}, le silicium peut être présent dans cette phase en une teneur atomique comprise entre 45% et 49%.

On donne ci-dessous au tableau 1 à titre illustratif quelques exemples de stoechiométrie de phases du revêtement protecteur que l'on peut obtenir dans le cadre de l'invention.

**Tableau 1**

| | M ou M' = Fe | M ou M' = Co | M ou M' = Ni |
|---|---|---|---|
| Mélange A | Nb_{21,3}Fe₂₄Cr_{8,9}Si_{45,8} | N b_{21,3}Co_{18,9}Cr_{13,9}Si_{45,9} | Nb_{22,1}Ni_{19,7}Cr_{13,5}Si_{44,6} |
| Mélange B | Nb_{25,7}Fe_{27,1}Si₄₇ | Nb_{26,7}Co_{26,3}Si_{46,7} | Nb_{27,2}Ni_{26,6}Si_{45,9} |

De préférence, M peut désigner Co ou Ni. De manière particulièrement préférée, M désigne Ni.

Dans un exemple de réalisation, le revêtement protecteur peut avoir une épaisseur supérieure ou égale à 15µm, par exemple comprise entre 15 µm et 50 µm.

Dans un exemple de réalisation, la pièce peut être une aube de turbomachine. En variante, la pièce est destinée à faire partie intégrante d'une chambre de combustion ou à constituer un distributeur ou un anneau de turbine.

La présente invention vise également une turbomachine comportant une pièce telle que définie plus haut.

La présente invention vise également un aéronef comportant une turbomachine telle que définie plus haut.

### Brève description des dessins

D'autres caractéristiques et avantages de l'invention ressortiront de la description suivante, en référence aux dessins annexés, sur lesquels :
- la figure 1 représente, de manière schématique et partielle, une section d'une pièce selon l'invention,
- la figure 2 représente, de manière schématique et partielle, un réacteur utilisable pour la mise en oeuvre d'un procédé selon l'invention,
- la figure 3 illustre, d'une manière simplifiée, le schéma réactionnel permettant la formation d'un revêtement protecteur dans le cadre d'un procédé selon l'invention,
- les figures 4A à 4C sont des photographies de différents revêtements protecteurs obtenus sur la surface d'alliages Nbₛₛ-Nb₅Si₃ par mise en oeuvre d'un exemple de réalisation de procédé selon l'invention,
- les figures 5A à 5C sont des photographies d'autres revêtements protecteurs obtenus sur la surface d'alliages Nb-Si par mise en oeuvre d'une variante de procédé selon l'invention, et
- La figure 6 représente les résultats d'essais d'oxydation cyclique à 1100°C sur pièces Nb-Si revêtues par des revêtements protecteurs selon l'invention en comparaison avec une pièce Nb-Si non revêtue.

### Description détaillée de modes de réalisation

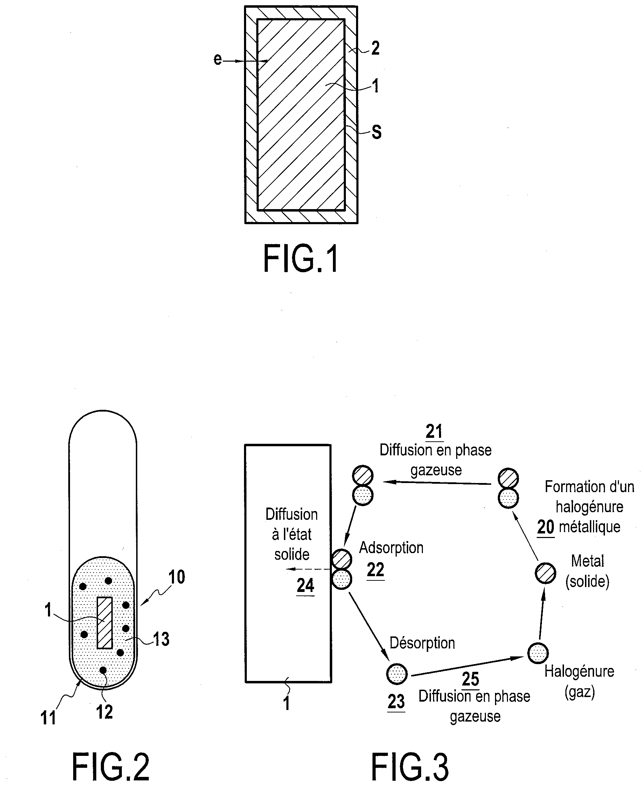

On a représenté, à la figure 1, une section d'une pièce 1 revêtue d'un revêtement protecteur 2. Le revêtement protecteur 2 est formé sur la surface S de la pièce 1 laquelle comporte une matrice de niobium dans laquelle des inclusions de siliciures métalliques sont présentes.

L'épaisseur e du revêtement protecteur 2 formé peut, par exemple, être comprise entre 15 µm et 50 µm. L'épaisseur e du revêtement protecteur 2 correspond à sa plus grande dimension mesurée perpendiculairement à la surface S de la pièce 1.

On a représenté à la figure 2 un réacteur utilisable dans le cadre d'un procédé selon l'invention. Comme illustré, ce réacteur se présente sous la forme d'une enceinte 10 dans laquelle la pièce 1 à traiter est présente. La pièce 1 est présente dans un cément 11 lequel comporte, d'une part, un mélange d'alliages donneurs 13 et, d'autre part, un agent activant 12. La pièce 1 est, comme illustré, au contact du cément 11. La composition du mélange d'alliages donneurs 13 est choisie en fonction du revêtement protecteur à obtenir sur la pièce 1. Le mélange d'alliages donneurs 13 peut être un mélange A ou un mélange B, ces mélanges étant définis plus haut.

L'agent activant 12 peut, par exemple, être choisi parmi : SiCl₄, SiF₄, NH₄Cl, NH₄F, les halogénures métalliques comme les fluorures ou chlorures métalliques, par exemple CrCl₃, et leurs mélanges. Les alliages donneurs 13 et l'agent activant 12 sont chacun sous la forme d'une poudre.

L'agent activant 12 peut être présent dans le cément, avant le début du procédé de cémentation en caisse, en une teneur massique comprise entre 0,5 % et 2 % de la masse totale du mélange d'alliages donneurs 13 dans le cément. La cémentation en caisse s'effectue dans l'enceinte 10.

Le cément 11 comporte, en outre, un diluant inerte, comportant par exemple de la silice (SiO₂) et/ou de l'alumine (Al₂O₃), par exemple sous la forme d'un mélange de Al₂O₃ et de SiO₂. Le diluant inerte permet avantageusement d'éviter l'agglomération des particules de cément à la surface de la zone à revêtir lors de la mise en température de l'ensemble. Le diluant inerte peut être présent sous forme de poudre dans le cément avant le début du procédé de cémentation en caisse.

La masse de diluant inerte dans le cément peut, avant le début du procédé de cémentation en caisse, être comprise entre 0,8 fois et 1,2 fois la masse totale du mélange d'alliages donneurs 13 dans le cément, et par exemple être sensiblement égale à la masse totale du mélange d'alliages donneurs 13 dans le cément.

Afin d'initier le procédé selon l'invention, l'enceinte 10 est portée à une température, par exemple, comprise entre 1100°C et 1300°C. L'enceinte 10 durant tout ou partie du procédé selon l'invention peut, par exemple, être remplie de gaz inerte ou être portée sous vide primaire ou vide secondaire.

Dans une première étape 20, un halogénure métallique est formé à partir d'un métal provenant des alliages donneurs et d'un halogénure provenant de l'agent activant. L'halogénure métallique ainsi formé diffuse ensuite dans la phase gazeuse jusqu'à la pièce 1 à traiter (étape 21) sur laquelle il s'adsorbe (étape 22). Il y a ensuite décomposition de l'halogénure métallique c'est-à-dire séparation entre le métal et l'halogénure (étape 23). Le métal est déposé à la surface de la pièce 1 et peut ensuite diffuser au sein de celle-ci (étape 24) et l'halogénure rejoint la phase gazeuse. L'halogénure diffusant dans la phase gazeuse (étape 25) peut, au contact des alliages donneurs, former à nouveau un halogénure métallique et réinitier le cycle de formation du revêtement protecteur venant d'être décrit.

### Exemples

Sauf mention contraire, les compositions des phases du revêtement protecteur données ci-dessous sont données en proportions atomiques.

### Exemple 1

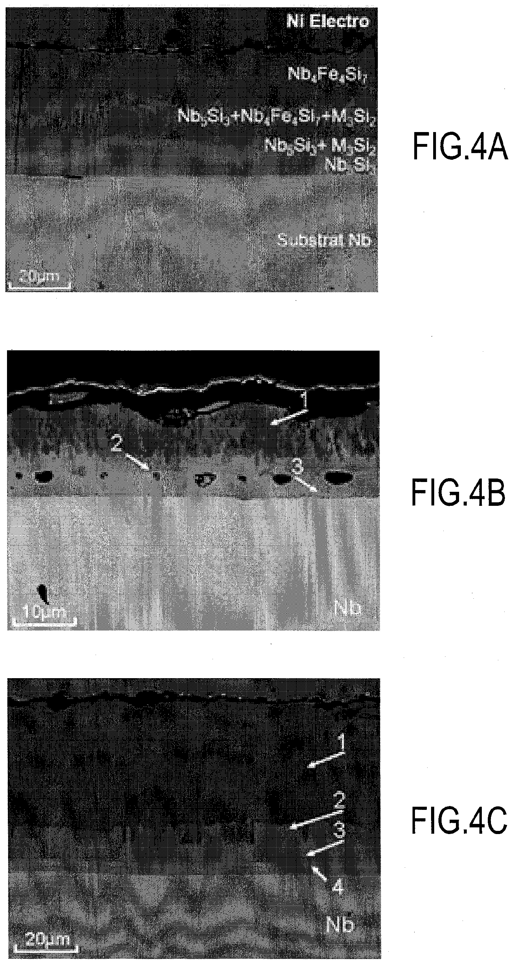

Chacune des figures 4A à 4C est une photographie d'une pièce revêtue d'un revêtement protecteur obtenu par mise en oeuvre d'un procédé selon l'invention.

Dans cet exemple, les revêtements protecteurs ont été formés par mise en oeuvre de mélanges B suivants (les proportions sont massiques) :
- Figure 4A : 20%FeSi + 20%NbSi₂ + 60%Nb₄Fe₄Si₇ ;
- Figure 4B : 10%CoSi + 10%NbSi₂ + 80%Nb₄Co₄Si₇ ;
- Figure 4C : 20% NiSi + 20%NbSi₂ + 60%Nb₄Ni₄Si₇.

Pour ces trois types de revêtements, la pièce et le cément sont maintenus à une température de 1200°C durant le procédé de cémentation en caisse et la durée du procédé de cémentation en caisse est de 24 heures. Comme illustré sur cette figure, les revêtements protecteurs formés comportent une pluralité de phases distinctes. Ces différentes phases se présentent sous la forme d'un empilement et sont superposées les unes avec les autres.

A la figure 4B, la phase notée « 1 » correspond à du Nb_{27,7}Co_{26,9}Si_{45,9}, la phase notée « 2 » correspond à du Nb_{60,8}Co_{0,9}Si_{38,2} et la phase notée « 3 » correspond à du Nb_{62,7}Si_{36,7}.

A la figure 4C, la phase notée « 1 » correspond à du Nb_{32,6}Ni_{0,2}Si_{67,3}, la phase notée « 2 » correspond à du Nb_{29,3}Ni_{25,3}Si_{45,4}, la phase notée « 3 » correspond à du Nb_{40,3}Ni_{19,7}Si_{39,9} et la phase notée « 4 » correspond à du Nb_{62,7}Si_{37,2}.

### Exemple 2

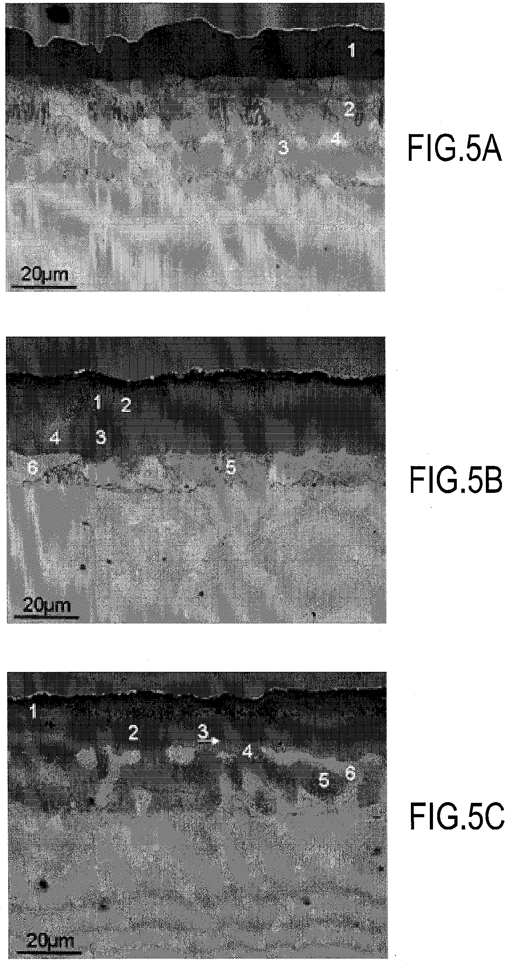

Chacune des figures 5A à 5C est une photographie d'une pièce revêtue d'un revêtement protecteur obtenu par mise en oeuvre d'un procédé selon l'invention.

Dans cet exemple, les revêtements protecteurs ont été formés par mise en oeuvre de mélanges A détaillés au tableau 2 ci-dessous à la colonne « Alliages donneurs »). Les teneurs figurant pour les alliages donneurs sont des teneurs massiques. La nature chimique des phases obtenues dans le revêtement protecteur sont précisées à la colonne « Composition Sonde des phases analysées ».

**Tableau 2**

| Alliages donneurs | Composition Sonde des phases analysées (%at.) | Section métallographique (MEB - image en électrons rétrodiffusés : « mode BSE ») représentée en |
|---|---|---|
| (1) 50% M₇Si₆-TiFe + 50% B20Fe | 1) Nb_{0,6}Ti_{16,1}Hf₀Cr_{15,9}Al₀Si₄₆Fe_{20,8} | Figure 5A |
| | 2) Nb_{18,4}Ti_{11,6}Hf₆Cr_{3,2}Al_{0,2}Si_{43,4}Fe_{16,5} | |
| | 3) Nb_{32,3}Ti_{17,2}Hf_{3,1}Cr_{1,1}Al_{0,1}Si_{44,4} Fe_{1,9} | |
| | 4) Nb_{26,5}Ti_{17,8}Hf_{9,1}Cr_{0,7}Al_{0,1}Si_{45,1}Fe_{0,6} | |
| (2) 50% M₇Si₆-TiCo + 50% B20Co | 1) Nb_{10,5}Ti_{9,9}Hf_{2,8}Cr_{12,7}Al₀Si_{46,6}CO_{17,1} | Figure 5B |
| | 2) Nb_{13,3}Ti_{9,3}Hf₁Cr_{12,6}Al₀Si_{46,2}Co_{17,2} | |
| | 3) Nb_{17,3}Ti_{7,7}Hf_{1,6}Cr_{2,9}Al₀Si_{46,7}Co_{23,5} | |
| | 4) Nb_{14,2}Ti_{9,1}Hf_{5,1}Cr_{3,4}Al₀Si_{46,2}Co_{21,6} | |
| | 5) Nb_{31,8}Ti₁₇Hf_{2,7}Cr_{2,6}Al₀Si_{41,9}Co_{3,9} | |
| | 6) Nb_{23,5}Ti_{19,9}Hf_{10,1}Cr_{0,5}Al₀Si_{45,7}Co_{0,3} | |
| (3) 50% M₇Si₆-TiNi + 50% B20Ni | 1) Nb_{11,1}Ti_{13,1}Hf_{0,8}Cr_{27,7}Al₀Si_{44,7}Ni_{2,4} | Figure 5C |
| | 2) Nb_{17,1}Ti_{10,1}Hf_{1,9}Cr_{12,5}Al₀Si₄₄Ni_{14,1} | |
| | 3) Nb₁₄Ti_{10,7}Hf_{4,1}Cr_{11,9}Al₀Si_{44,4}Ni_{14,7} | |
| | 4) Nb_{26,1}Ti_{12,4}Hf_{1,9}Cr_{3,8}Al₀Si_{42,9}Ni_{12,8} | |
| | 5) Nb₃₂Ti_{17,2}Fif_{2,5}Cr₂Al_{0,2}Si_{41,3}Ni_{4,8} | |
| | 6) Nb_{22,8}Ti₂₀Hf_{10,4}Cr_{0,5}Al_{0,2}Si₄₆Ni_{0,2} | |

Pour le tableau 2 ci-dessus :
(1) M₇Si₆-TiFe = Ti₃Fe₃CrSi₆ et B20Fe = Fe_{0,6}Cr_{0,4}Si
(2) M₇Si₆-TiCo = Ti₃Co₃CrSi₆ et B20Co = Co_{0,6}Cr_{0,4}Si
(3) M₇Si₆-TiNi = Ti₃Ni₃CrSi₆ et B20Ni = Ni_{0,6}Cr_{0,4}Si

Pour ces trois types de revêtements, la durée du procédé de cémentation en caisse est de 24 heures et la pièce et le cément sont maintenus à 1200°C pendant le procédé de cémentation en caisse. La pièce revêtue est un alliage MASC décrit dans le brevet US 5942055 ayant la composition suivante en pourcentages atomiques : Nb = 47% ; Ti = 25 % ; Hf = 8 % ; Cr = 2 % ; Al = 2 % ; Si = 16 %.

### Exemple 3 : Essais d'oxydation cyclique à 1100°C sur pièces Nb-Nb₅Si₃ revêtues

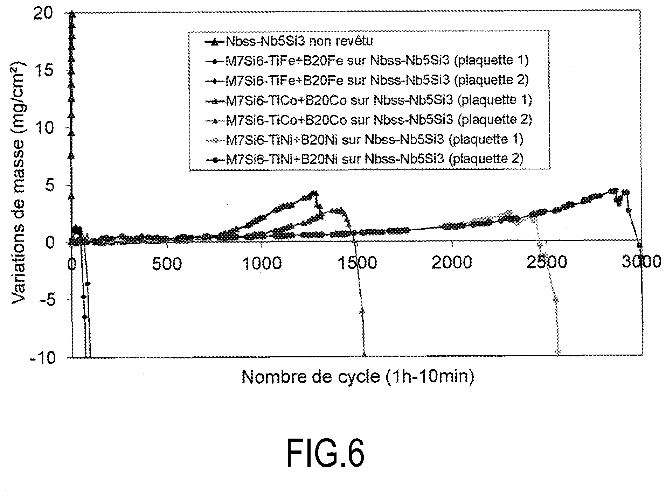

La protection contre l'oxydation conférée par des revêtements protecteurs a été évaluée. Ces revêtements ont été obtenus dans les mêmes conditions que celles de l'exemple 2. Les résultats sont répertoriés à la figure 6.

La durée de vie des pièces protégées par ces revêtements est améliorée par rapport à la pièce nue (i.e. sans revêtement). Lorsque M=Co, la durée de vie des pièces protégées est multipliée au moins par un facteur 15 par rapport à M=Fe et, lorsque M=Ni, la durée de vie des pièces protégées est multipliée par un facteur 30 par rapport à M=Fe. Comme reflété par la figure 6, les essais ont été doublés pour chacun des revêtements afin de prouver le caractère reproductible des résultats obtenus.

Les revêtements les plus performants résistent à environ 3000 cycles d'oxydation à 1100°C. En conditions cycliques, ces revêtements présentent une bonne résistance à l'oxydation jusqu'à 1200°C.

On voit qu'un alliage non revêtu s'oxyde très rapidement de manière très significative (forte augmentation de la masse suite à l'oxydation). Si la mise en contact avec le milieu oxydant est prolongée suffisamment, les oxydes formés vont ensuite s'écailler ce qui va conduire à une diminution de la masse comme pour les courbes représentées à la figure 6.

Par ailleurs, la formation de ces revêtements protecteurs sur des pièces à base de niobium peut avantageusement permettre de diviser par 200 les prises de masse enregistrées lors d'une exposition isotherme à 1100°C. Et en condition isotherme, ces revêtements peuvent avantageusement conférer une protection efficace jusqu'à 1300°C.

L'expression « comportant/contenant un(e) » doit se comprendre comme « comportant/contenant au moins un(e) ».

L'expression « compris(e) entre ... et ... » ou « allant de ... à ... » doit se comprendre comme incluant les bornes.

## Revendications

1. Procédé de fabrication d'une pièce (1) revêtue d'un revêtement protecteur (2) comportant l'étape suivante :
- formation d'un revêtement protecteur (2) sur tout ou partie de la surface (S) d'une pièce (1), la pièce (1) comportant un alliage réfractaire comportant une matrice de niobium dans laquelle des inclusions de siliciures métalliques sont présentes, le revêtement protecteur (2) étant formé par un procédé de cémentation en caisse à partir d'un cément (11) comportant :
i. un mélange A de (NbₓTi₁₋ₓ)₃M₃CrSi₆ et de M_{0,6}Cr_{0,4}Si où M désigne Fe, Co ou Ni et x est compris entre 0 et 1, ou
ii. un mélange B de M'Si, de NbSi₂ et de Nb₄M'₄Si₇ où M' désigne Fe, Co ou Ni.

2. Procédé selon la revendication 1, **caractérisé en ce que** le cément (11) comporte un mélange A et **en ce que** M désigne Co ou Ni.

3. Procédé selon la revendication 2, **caractérisé en ce que** M désigne Ni.

4. Procédé selon l'une quelconque des revendications 1 à 3, **caractérisé en ce que** le cément (11) comporte un mélange A et **en ce que** x = 0.

5. Procédé selon l'une quelconque des revendications 1 à 3, **caractérisé en ce que** le cément (11) comporte un mélange A et **en ce que** x est différent de 0.

6. Procédé selon la revendication 5, **caractérisé en ce que** x=1.

7. Procédé selon l'une quelconque des revendications 1 à 6, **caractérisé en ce que** le cément (11) comporte un mélange A et **en ce que** le rapport (masse de (NbₓTi₁₋ₓ)₃M₃CrSi₆ dans le cément (11) avant le début du procédé de cémentation en caisse) / (masse de M_{0,6}Cr_{0,4}Si dans le cément (11) avant le début du procédé de cémentation en caisse) est compris entre 0,9 et 1,1.

8. Procédé selon la revendication 1, **caractérisé en ce que** le cément (11) comporte un mélange B et **en ce que** avant le début du procédé de cémentation en caisse :
- le rapport (masse de M'Si dans le cément (11))/(masse totale du mélange B dans le cément (11)) est compris entre 5 % et 30%, et
- le rapport (masse de NbSi₂ dans le cément (11))/(masse totale du mélange B dans le cément (11)) est compris entre 5% et 30%, et
- le rapport (masse de Nb₄M'₄Si₇ dans le cément (11))/(masse totale du mélange B dans le cément (11)) est compris entre 50% et 80%.

9. Procédé selon l'une quelconque des revendications 1 à 8, **caractérisé en ce que** la pièce (1) est soumise à une température comprise entre 1100°C et 1300°C durant tout ou partie de l'étape de formation du revêtement protecteur (2).

10. Procédé selon l'une quelconque des revendications 1 à 9, **caractérisé en ce que** l'épaisseur (e) du revêtement protecteur (2) formé est comprise entre 15 µm et 50 µm.

11. Pièce (1) comportant un alliage réfractaire comportant une matrice de niobium dans laquelle des inclusions de siliciures métalliques sont présentes, la surface de la pièce (1) étant revêtue par un revêtement protecteur (2), le revêtement protecteur (2) comportant une phase ayant la stoechiométrie :
- (NbₓTi₁₋ₓ)₃M_{β}Cr_{γ}Si_{δ}X_{ε} où M désigne Fe, Co ou Ni, X désigne un ou plusieurs autres éléments éventuellement présents, x est compris entre 0 et 1, δ est compris entre 5 et 8,5 et la somme β+γ est comprise entre 3 et 7, ou
- Nb₄M'_{η}Si_{θ}X'_{ε'} où M' désigne Fe, Co ou Ni, X' désigne un ou plusieurs autres éléments éventuellement présents, η est compris entre 3,2 et 4,8 et θ est compris entre 6 et 8.

12. Turbomachine comportant une pièce (1) selon la revendication 11.

13. Aéronef comportant une turbomachine selon la revendication 12.

## Patentansprüche

1. Verfahren zum Herstellen eines Teils (1), das mit einem Schutzüberzug (2) beschichtet ist, umfassend den folgenden Schritt:
- Ausbilden eines Schutzüberzugs (2) auf der gesamten Oberfläche (S) eines Teils (1) oder einem Teil dieser, wobei das Teil (1) eine feuerfeste Legierung umfasst, die eine Niobmatrix umfasst, in der Einschlüsse von Metallsiliziden vorhanden sind, wobei der Schutzüberzug (2) durch ein festes Einsatzhärteverfahren aus einem Einsatzmittel (11) gebildet ist, umfassend
i. eine Mischung A aus (NbₓTi₁₋ₓ)₃M₃CrSi₆ und aus M_{0,6}Cr_{0,4}Si, worin M Fe, Co oder Ni bezeichnet und x im Bereich zwischen 0 und 1 liegt, oder
ii. eine Mischung B aus M'Si, aus NbSi₂ und aus Nb₄M'₄Si₇, worin M' Fe, Co oder Ni bezeichnet.

2. Verfahren nach Anspruch 1, **dadurch gekennzeichnet, dass** das Einsatzmittel (11) eine Mischung A enthält und dass M Co oder Ni bezeichnet.

3. Verfahren nach Anspruch 2, **dadurch gekennzeichnet, dass** M Ni bezeichnet.

4. Verfahren nach einem der Ansprüche 1 bis 3, **dadurch gekennzeichnet, dass** das Einsatzmittel (11) eine Mischung A enthält und dass x = 0 ist.

5. Verfahren nach einem der Ansprüche 1 bis 3, **dadurch gekennzeichnet, dass** das Einsatzmittel (11) eine Mischung A enthält und dass x von 0 verschieden ist.

6. Verfahren nach Anspruch 5, **dadurch gekennzeichnet, dass** x = 1 ist.

7. Verfahren nach einem der Ansprüche 1 bis 6, **dadurch gekennzeichnet, dass** das Einsatzmittel (11) eine Mischung A enthält und dass das Verhältnis (Masse von (NbₓTi₁₋ₓ)₃M₃CrSi₆ in dem Einsatzmittel (11) vor Beginn des festen Einsatzhärteverfahrens) / (Masse von M_{0,6}Cr_{0,4}Si in dem Einsatzmittel (11) vor Beginn des festen Einsatzhärteverfahrens) im Bereich zwischen 0,9 und 1,1 liegt.

8. Verfahren nach Anspruch 1, **dadurch gekennzeichnet, dass** das Einsatzmittel (11) eine Mischung B enthält und dass vor Beginn des festen Einsatzhärteverfahrens:
- das Verhältnis (Masse von M'Si in dem Einsatzmittel (11))/(Gesamtmasse der Mischung B in dem Einsatzmittel (11)) zwischen 5 % und 30 % beträgt, und
- das Verhältnis (Masse von NbSi₂ in dem Einsatzmittel (11))/(Gesamtmasse der Mischung B in dem Einsatzmittel (11)) zwischen 5 % und 30 % beträgt, und
- das Verhältnis (Masse von Nb₄M'₄Si₇ in dem Einsatzmittel (11))/(Gesamtmasse der Mischung B in dem Einsatzmittel (11)) zwischen 50 % und 80 % beträgt.

9. Verfahren nach einem der Ansprüche 1 bis 8, **dadurch gekennzeichnet, dass** das Teil (1) während des gesamten Schrittes zum Ausbilden des Schutzüberzugs (2) oder eines Teils dessen einer Temperatur im Bereich zwischen 1100 °C und 1300 °C ausgesetzt wird.

10. Verfahren nach einem der Ansprüche 1 bis 9, **dadurch gekennzeichnet, dass** die Dicke (e) des ausgebildeten Schutzüberzugs (2) zwischen 15 µm und 50 µm beträgt.

11. Teil (1), umfassend eine feuerfeste Legierung mit einer Niobmatrix, in der Einschlüsse von Metallsiliziden vorhanden sind, wobei die Oberfläche des Teils (1) mit einem Schutzüberzug (2) beschichtet ist, wobei der Schutzüberzug (2) eine Phase aufweist mit der Stöchiometrie:
- (NbₓTi₁₋ₓ)₃M_{β}Cr_{γ}Si_{δ}X_{ε}, worin M Fe, Co oder Ni bezeichnet, X ein oder mehrere weitere eventuell vorhandene Elemente bezeichnet, x im Bereich zwischen 0 et 1 liegt, δ im Bereich zwischen 5 et 8,5 liegt, und die Summe β + γ im Bereich zwischen 3 und 7 liegt, oder
- Nb₄M'_{η}Si_{θ}X'_{ε'}, worin M' Fe, Co oder Ni bezeichnet, X' ein oder mehrere weitere eventuell vorhandene Elemente bezeichnet, η im Bereich zwischen 3,2 und 4,8 liegt und θ im Bereich zwischen 6 und 8 liegt.

12. Turbomaschine, die ein Teil (1) nach Anspruch 11 umfasst.

13. Luftfahrzeug, das eine Turbomaschine nach Anspruch 12 umfasst.

## Claims

1. A method of fabricating a part (1) coated with a protective coating (2) and comprising the following step:
• forming a protective coating (2) over all or part of the surface (S) of the part (1), the part (1) comprising a refractory alloy having a niobium matrix with inclusions of metal silicides present therein, the protective coating (2) being formed by a pack cementation process using a cement (11) comprising:
i) a mixture A of (NbₓTi₁₋ₓ)₃M₃CrSi₆ and of M_{0.6}Cr_{0.4}Si, where M designates Fe, Co, or Ni and x lies in the range 0 to 1; or
ii) a mixture B of M'Si, of NbSi₂, and of Nb₄M'₄Si₇, where M' designates Fe, Co, or Ni.

2. A method according to claim 1, **characterized in that** the cement (11) comprises a mixture A and **in that** M designates Co or Ni.

3. A method according to claim 2, **characterized in that** M designates Ni.

4. A method according to any one of claims 1 to 3, **characterized in that** the cement (11) comprises a mixture A and **in that** x=0.

5. A method according to any one of claims 1 to 3, **characterized in that** the cement (11) comprises a mixture A and **in that** x is not equal to 0.

6. A method according to claim 5, **characterized in that** x=1.

7. A method according to any one of claims 1 to 6, **characterized in that** the cement (11) comprises a mixture A and **in that** the ratio [weight of (NbₓTi₁₋ₓ)₃M₃CrSi₆ in the cement (11) before the beginning of the pack cementation process] / [weight of M_{0.6}Cr_{0.4}Si in the cement (11) before the beginning of the pack cementation process] lies in the range 0.9 to 1.1.

8. A method according to claim 1, **characterized in that** the cement (11) comprises a mixture B and **in that** before the beginning of the pack cementation process:
• the ratio [weight of M'Si in the cement (11)] / [total weight of the mixture B in the cement (11)] lies in the range 5% to 30%; and
• the ratio [weight of NbSi₂ in the cement (11)] / [total weight of the mixture B in the cement (11)] lies in the range 5% to 30%; and
• the ratio [weight of Nb₄M'₄Si₇ in the cement (11)] / [total weight of the mixture B in the cement (11)] lies in the range 50% to 80%.

9. A method according to any one of claims 1 to 8, **characterized in that** the part (1) is subjected to a temperature lying in the range 1100°C to 1300°C throughout all or part of the step of forming the protective coating (2).

10. A method according to any one of claims 1 to 9, **characterized in that** the thickness (e) of the protective coating (2) formed lies in the range 15 µm to 50 µm.

11. A part (1) comprising a refractory alloy comprising a niobium matrix having metal silicide inclusions present therein, the surface of the part (1) being coated by a protective coating (2), the protective coating (2) comprising a phase having the following stoichiometry:
• (NbₓTi₁₋ₓ)₃M_{β}Cr_{γ}Si_{δ}X_{ε} where M designates Fe, Co, or Ni, X designates one or more other elements that might be present, x lies in the range 0 to 1, δ lies in the range 5 to 8.5, and the sum β+γ lies in the range 3 to 7; or
• Nb₄M'_{η}Si_{θ}X'_{ε'} where M' designates Fe, Co, or Ni, X' designates one or more other elements that might be present, η lies in the range 3.2 to 4.8, and θ lies in the range 6 to 8.

12. A turbine engine including a part (1) according to claim 11.

13. An aircraft including a turbine engine according to claim 12.
